# FASCICULE DE BREVET EUROPEEN

(11) **EP 0 302 789 B1**
(45) Date de publication et mention de la délivrance du brevet: **13.01.1993**
(21) Numéro de dépôt: 88402025.6
(22) Date de dépôt: 03.08.1988
(51) Int. Cl.: H01L 27/06, H02J 7/24

(54) **Régulateur monolithique du courant d'excitation de l'inducteur d'un alternateur à diode de recirculation intégrée en technologie d'intégration verticale**
In vertikaler Integrationstechnologie hergestellter integrierter monolitischer Regulator des Induktionsanregungsstromes eines Wechselstromgenerators mittels einer Wiederdurchflussdiode
Monolithic alternator field coil fed regulator with integrated refreshing diode formed using vertical integration technology

(30) Priorité: 05.08.1987 FR 8711133
(43) Date de publication de la demande: 08.02.1989
(73) Titulaire: VALEO EQUIPEMENTS ELECTRIQUES MOTEUR, 94000 Créteil (FR)
(72) Inventeur: Pierret, Jean-Marie, F-75012 Paris (FR)
(74) Mandataire: Schrimpf, Robert

(56) Documents cités:
- EP-A- 0 229 482
- DE-A- 1 588 072
- DE-A- 2 601 140
- DE-B- 2 026 778
- IEEE JOURNAL OF SOLID-STATE CIRCUITS volume SC 8, no. 6, decembre 1973, pages 419-427; F.W.DAVIS: "Bipolar design considerations for the automotive environment"

## Description

L'invention est relative à un régulateur monolithique du courant d'excitation de l'inducteur d'un alternateur en technique d'intégration verticale.

Les régulateurs du courant d'excitation de l'inducteur d'un alternateur, tel qu'un alternateur d'automobile, sont actuellement réalisés sous forme de circuit intégré. De tels circuits intégrés pour l'automobile sont connus du document IEEE J. Solid State Circuits, vol. SC-8, no. 6, 1973, pages 419-427.

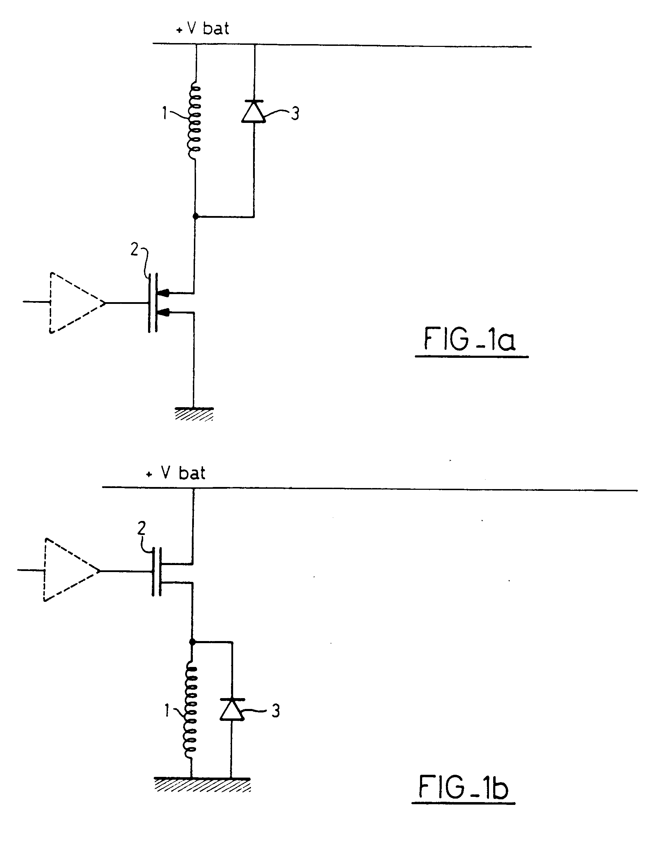

Selon un premier mode de montage classique, l'inducteur 1, ainsi que représenté en figure 1a, est connecté entre la borne positive de la batterie et la borne de commutation, borne de drain, d'un transistor (2) de commutation de puissance de type MOS dont l'électrode de source est connectée au potentiel de référence. L'électrode de grille du transistor MOS de commutation de puissance est commandée par des impulsions de rapport cyclique donné et le courant injecté dans l'inducteur est directement proportionnel au rapport cyclique des impulsions de commande. Une diode 3 appelée diode de recirculation est montée en parallèle sur l'inducteur, cette diode ayant pour fonction d'empêcher l'annulation du courant dans l'inducteur lorsque le transistor de type MOS est bloqué. La diode de recirculation est polarisée en inverse lorsque le transistor MOS de commutation est conducteur.

Un deuxième mode de montage dit montage en commutation "high side", en langage anglosaxon, consiste à connecter l'inducteur 1 et la diode de recirculation 3, ainsi que représenté en figure 1b, directement au potentiel de référence, le transistor MOS de commutation étant directement connecté entre l'inducteur 1 et la batterie d'alimentation.

Ce mode de montage a pour avantage de réduire les parasites engendrés par les transitoires de commutation, l'une des bornes de l'inducteur étant toujours reliée au potentiel de référence;
en outre, en cas de détérioration d'un des balais de contact de l'inducteur, par mise en court-circuit de ce balai avec le potentiel de référence, la mise à l'état plein champ de l'alternateur est évitée, ainsi que la destruction de la batterie par sur-alimentation.

Les régulateurs monolithiques actuellement disponibles dans le commerce sont réalisés en technologie dérivée de la technologie bipolaire.

Dans ce type de technologie, les différents éléments du circuit intégré sont séparés par des "caissons d'isolement" réalisés sous forme de jonctions toujours polarisées en inverse, donc à l'état non conducteur. Cette polarisation en inverse des caissons est réalisée en reliant le potentiel de référence au substrat du circuit intégré, lequel potentiel de référence doit toujours être le potentiel le plus négatif.

Cette condition n'est pas réalisée dans le cas du deuxième mode de montage en commutation "high side" lorsque la diode de recirculation 3 devient passante. Dans ce cas, elle joue le rôle d'une jonction émetteur-base de transistor parasite dont les collecteurs sont constitués par les caissons voisins. Un régulateur monolithique, réalisé dans la technologie précitée, ne peut être facilement utilisé selon le deuxième mode de montage précédemment décrit, dit à commutation "high side".

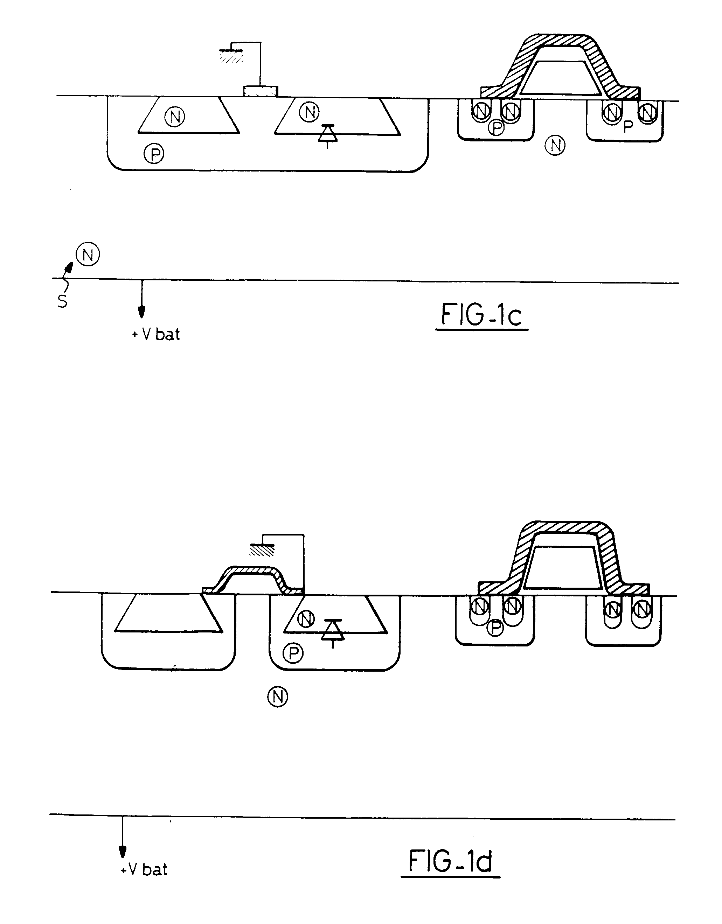

Un autre type de technologie, dite technologie verticale, permet de résoudre ce problème selon l'invention. Cette technologie est dérivée de la technologie utilisée pour les transistors de puissance MOS, dans laquelle le courant délivré par ce transistor MOS traverse verticalement la plaquette de silicium. Cette technologie est obtenue en plaçant à côté du transistor MOS une zone commande comportant des caissons d'isolement selon la figure 1C. Pour l'application concernant un régulateur monolithique, l'un des caissons contient la diode de recirculation 3. Lorsque le régulateur est monté conformément au deuxième mode de montage précédent "high side", afin de bénéficier des avantages de celui-ci, et dans le cas où, au cours de la commutation, la diode de recirculation est polarisée dans le sens passant, le même phénomène d'effet transistor parasite apparaît et présente les mêmes inconvénients que précédemment mentionnés. Cependant, la technologie dite verticale permet de réaliser des caissons d'isolement séparés ou indépendants, c'est-à-dire ne comportant pas de mur d'isolement commun, particularité impossible à réaliser avec la première technologie précitée, dérivée de la technologie bipolaire. Cette particularité de réaliser des caissons d'isolement indépendants est utilisée, selon l'invention, pour supprimer l'effet transistor parasite.

On a proposé afin de supprimer l'effet transistor parasite précédemment mentionné, dans le cas de régulateurs réalisés en technologie verticale, de relier en surface par une métallisation de liaison le caisson d'isolement de la diode de recirculation et le caisson d'isolement de la zone de circuit de commande, les caissons précités ayant été rendus indépendants, ainsi que représenté en figure 1d. Cette liaison, en raison de son caractère de conduction métallique et non semi-conductrice, a pour effet de supprimer l'effet transistor parasite entre caissons. Mais la solution précitée n'élimine pas l'effet transitor parasite entre des jonctions de diodes formées par le substrat, le caisson d'isolement de la zone diode de recirculation et la jonction diode de la diode de recirculation elle-même. Cet effet parasite a pour inconvénient d'engendrer un courant parasite délivré par la batterie d'alimentation, lequel provoque une surconsommation non négligeable liée à des risques d'échauffement.

La présente invention a pour but de remédier aux inconvénients précités par la mise en oeuvre d'un régulateur monolithique en technologie verticale, susceptible d'être utilisé selon le montage dit en commutation "high side", représenté en figure 1b et dans lequel tout effet de transistor parasite est supprimé.

Le régulateur monolithique du courant d'excitation de l'inducteur d'un alternateur, objet de l'invention, est defini dans la revendication 1.

Le régulateur objet de l'invention trouve application à la mise en oeuvre de circuits d'excitation d'alternateurs de véhicules automobiles.

L'invention sera mieux comprise à la lecture de la description et à l'observation des dessins dans lesquels, outre la figure 1a, 1b, 1c, 1d, relative à des montages ou dispositifs de l'art antérieur,

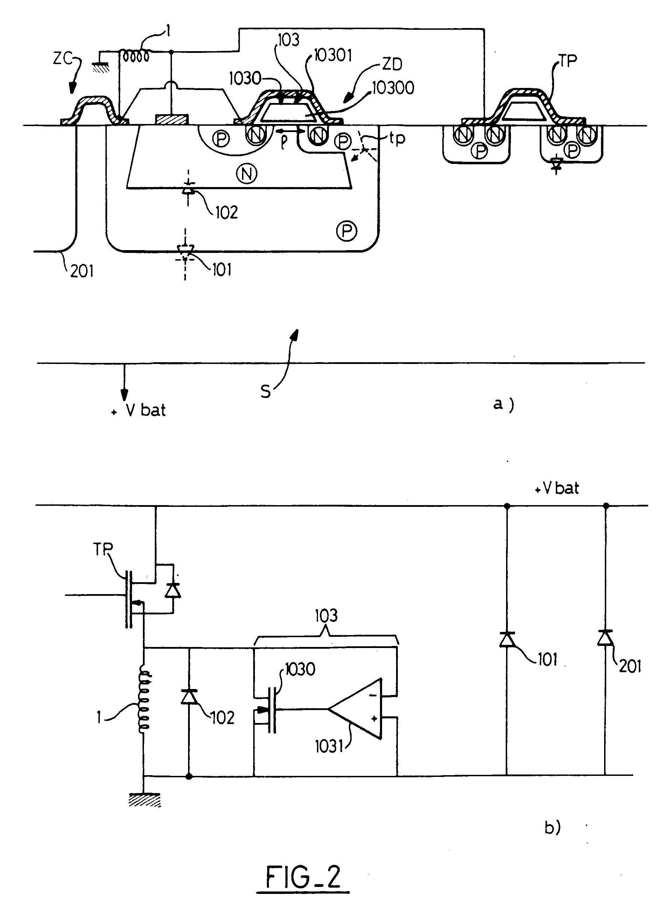

- la figure 2 point a) représente un schéma partiel d'implantation d'un régulateur monolithique conforme à l'objet de la présente invention, selon un premier mode de réalisation non limitatif,
- la figure 2 point b) représente un schéma électrique équivalent du régulateur représenté en figure 2a,
- la figure 3a représente un schéma d'implantation d'un régulateur monolithique conforme à l'objet de la présente invention, selon un mode de réalisation préférentiel, non limitatif,
- la figure 3b représente un schéma électrique équivalent du régulateur représenté en figure 3a,
- la figure 4 représente un détail de réalisation de la face supérieure dite face d'intégration du substrat dans un premier mode de réalisation non limitatif,
- la figure 5 représente un détail de réalisation de la face supérieure, dite face d'intégration du substrat dans une variante de réalisation non limitative,
- la figure 6 représente un autre détail de réalisation.

Le régulateur monolithique du courant d'excitation de l'inducteur d'un alternateur objet de l'invention, sera tout d'abord décrit en liaision avec la figure 2 et en particulier en référence aux points a et b de celle-ci.

Le régulateur monolithique du courant d'excitation de l'inducteur 1 d'un alternateur objet de l'invention comprend sur un même substrat S de matériau semi-conducteur, un transistor de puissance de type MOS, ce transistor étant noté TP. On comprendra bien entendu que le transistor de puissance TP peut en fait être constitué par une pluralité de cellules transistors MOS. Les cellules transistors MOS élémentaires sont connectées en parallèle. Ce mode de réalisation classique ne sera pas décrit car il est parfaitement connu de l'homme de métier.

Le régulateur monolithique du courant d'excitation de l'inducteur d'un alternateur objet de l'invention comporte également une zone de commande notée ZC, permettant d'assurer la commande de commutation du courant d'alimentation de l'inducteur 1 en fonction du rapport cyclique des impulsions de commande ainsi que mentionné précédemment. La zone de circuit de commande ZC ne sera pas décrite en détail, car elle correspond au circuit de commande classique du courant d'excitation de l'inducteur d'un alternateur, circuit de commande normalement présente dans les régulateurs monolithiques de courant d'excitation de l'inducteur d'un alternateur normalement disponible dans le commerce.

Le substrat S ainsi que représenté notamment en figure 2 au point a) comporte également une zone de diode de recirculation notée ZD, cette zone de diode de recirculation ZD permettant d'assurer la fonction de diode de recirculation ainsi que décrit précédemment dans l'introduction à la description.

Conformément à une caractéristique particulièrement avantageuse du régulateur objet de l'invention, chacune des zones, zone de circuit de commande ZC et zone de diode de recirculation ZD, est isolée du substrat S par un caisson d'isolement indépendant. Les caissons d'isolement indépendants sont avantageusement constitués par une diode notée 101, respectivement 201.

Ainsi qu'on le notera en particulier sur la figure 2 au point a) de celle-ci, le caisson d'isolement 101 de la zone de diode de recirculation et la zone de diode de recirculation ZD présente au moins deux jonctions diodes notées 101,102, en cascade. Ces deux jonctions diodes en cascade 101,102 sont susceptibles lors de l'inversion de polarité de la tension appliquée à l'inducteur 1 de constituer un transistor parasite noté tp, et représenté en trait pointillé sur la figure 2 au point a). On notera également que sur cette même figure, les diodes de jonction 101 et 102 sont symbolisées par le schéma symbolique d'une diode représentée en trait pointillé.

Conformément à un aspect particulièrement avantageux de l'objet de l'invention, la jonction de diode 102 susceptible de constituer la jonction émetteur base du transistor parasite tp, est court-circuitée par des moyens de connexion notés 103, de façon à supprimer le courant de conduction parasite du transistor parasite tp.

En effet, dans cette configuration, la diode de recirculation 102, se comporte comme la jonction émetteur base du transistor parasite tp dont la jonction collecteur base est constituée par les jonctions de caisson d'isolement, la jonction diode 101, polarisée en inverse.

Sur la figure 2, au point b) de celle-ci, on a représenté le schéma équivalent électrique au schéma d'implantation des différentes zones précitées sur le substrat S. Du point de vue fonctionnement électrique, le transistor de puissance TP alimente l'inducteur 1 à partir de la tension positive d'alimentation de batterie notée +Vbat. Les diodes 101 et 201 sont les jonctions collecteur base constituées par les caissons d'isolement des zones de circuit de commande ZC et de diodes de recirculation ZD.

Lorsque la diode de recirculation 102 est à l'état passant, une partie du courant traverse la jonction diode 101, ce qui entraîne un échauffement excessif du substrat de celui-ci.

La mise en court-circuit de la jonction émetteur base du transistor parasite tp, jonction émetteur base constituée par la jonction de diode 102, a pour effet, bien entendu, de supprimer l'effet transistor parasite par le blocage de celui-ci.

Un premier mode de réalisation du régulateur monolithique objet de l'invention sera décrit de manière plus détaillée en liaison avec la figure 2 au point a) de celle-ci.

Ainsi qu'il apparaît sur la figure précitée, les moyens de connexion 103 permettant la mise en court-circuit de la jonction de la jonction émetteur base du transistor parasite tp, jonction constituée par la jonction de diode 102, peuvent comporter avantageusement un transistor de type MOS, noté 1030, lequel est superposé sensiblement sur la diode de recirculation 102. Ainsi qu'on l'a représenté en figure 2 au point a), et également au point b) de celle-ci, le transistor de type MOS 1030, présente une électrode de grille notée 10300, recouvrant les zones de matériau semi-conducteurs constituant la jonction émetteur base du transistor parasite tp. De manière classique, l'électrode de grille du transistor MOS 1030, comme l'électrode grille du transistor TP de puissance peut être constituée en matériau tel que du silicium polycristallin. Celui-ci ne présente pas de caractéristique semi-conductrice particulière mais permet la mise en court-circuit de la jonction de diode 102 constitutive de la jonction émetteur base du transistor parasite tp. En outre, ainsi qu'on l'a représenté en figure 2 aux points a) et b), un comparateur 1031 directement intégré au substrat S mais non représenté en figure 2 au point a) de celle-ci est connecté de façon que les entrées positive et négative de celui-ci soit respectivement reliée à la tension de référence du régulateur et à la borne commutée de l'inducteur 1. La borne commutée de l'inducteur 1 est bien entendu la borne qui est directement en contact avec l'électrode de source du transistor MOS de puissance TP.

En fonctionnement, le transistor MOS 1030 est commandé par le comparatuer 1031, comme suit. Lorsque le transistor de commutation TP alimente l'inducteur 1, la diode de recirculation 102 est bloquée ainsi que le transistor MOS 1030. Lorsque le transistor de puissance, de type MOS, TP passe à l'état bloqué, sur commande par les impulsions de commande ainsi que mentionné précédemment dans la description, la force électromotrice s'inverse aux bornes de l'inducteur 1 et le comparatuer 1031 réagit en rendant passant le transistor MOS 1030 superposé à la diode de recirculation 102. La conduction du transistor MOS 1030 entraîne la mise en court-circuit de la diode de recirculation 102 et le transistor parasite tp reste alors bloqué puisque sa jonction émetteur base est en court-circuit. La jonction de diode 101 joue alors uniquement le rôle de caisson d'isolement pour le transistor MOS 1030.

Afin d'assurer une bonne mise en court-circuit de la jonction émetteur base du transistor parasite tp constitué par la jonction de diode 102, le transistor MOS 1030 comporte une électrode de grille ainsi que précédemment mentionné 10300, présentant une largeur de recouvrement 1 de la jonction diode 102, permettant d'imposer le potentiel des zones de matériau semi-conducteur constitutives de la jonction précitée.

Bien entendu, les transistors de type MOS, transistor de puissance TP et transistor 1030, sont de structure classique, l'électrode de source de ces transistors étant constituée par une métallisation 10301 recouvrant l'électrode de grille 10300. L'électrode de source est ainsi constituée de manière classique par une métallisation. Sur la figure 2 au point a) de celle-ci, les zones de matériau semi-conducteur constitutives des transistors de type MOS, transistor de puissance TP et transistor 1030, et le type de ces zones de matériau semi-conducteur sont notés par les initiales classiques N ou P cerclées. La structure de ces transistors MOS ne sera pas décrite plus en détail car elle correspond à une structure classique de ce type de transistor. De la même manière, la nature semi-conductrice des zones constitutives des différentes jonctions diodes est indiquée par les initiales classiques N ou P cerclées. Les jonctions de diodes 101,102, constitutives respectivement du caisson d'isolement et de la diode de recirculation, sont obtenues de manière classique par diffusion d'impureté de type correspondant dans le substrat, lequel au départ, peut être constitué par exemple par un substrat de type N. De manière avantageuse, au niveau de l'électrode de grille 10300 du transistor MOS 1030, la jonction diode 102 présente un décrochement formant par rapport à la zone de type N une région de type "pod" ou surplomb permettant d'assurer une mise en court-circuit convenable de la jonction de diode 102, par l'électrode de - grille 10300 du transistor MOS 1030 ainsi que représenté sur la figure 2 au point a) de celle-ci. La région de type "pod" se trouve au voisinage de la flèche représentative de la largeur 1 de recouvrement. La diffusion des différentes impuretés dans le substrat est effectuée de manière classique à l'aide de technique de masquage et ne sera pas décrite en détail dans la description.

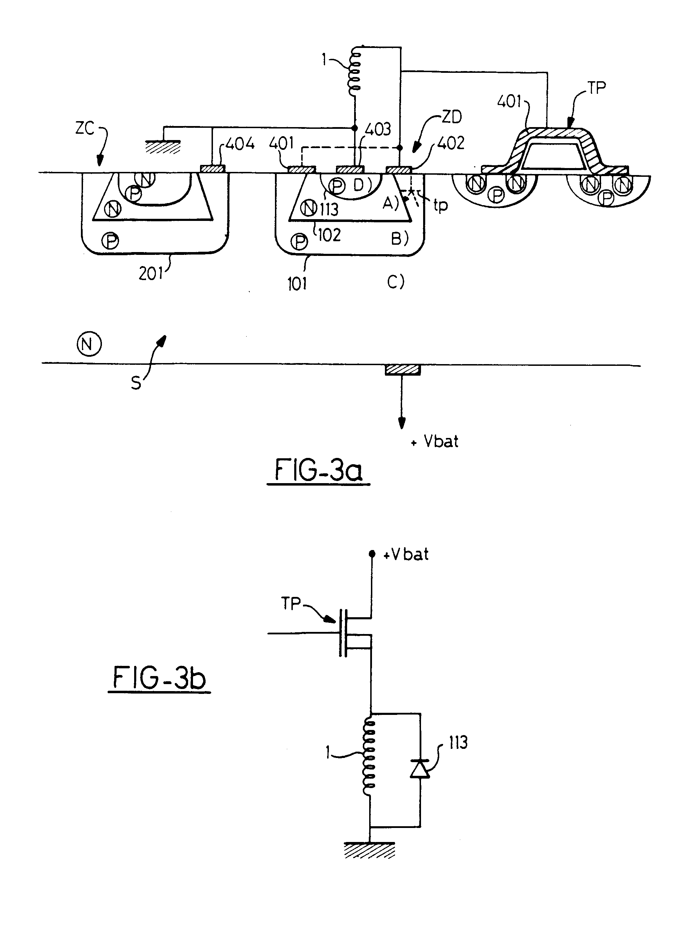

Un deuxième mode de réalisation particulièrement avantageux du régulateur monolithique du courant d'excitation de l'inducteur d'un alternateur conformément à l'objet de l'invention, sera décrit en liaison avec les figures 3a et 3b.

Conformément aux figures précitées, et de manière particulièrement avantageuse, la zone de diode de recirculation ZD, comporte disposée en cascade, une première jonction de diode 101, constituant le caisson d'isolement de la zone de diode de recirculation ZD. La première jonction diode 101 est portée à un potentiel flottant en fonctionnement, en particulier au potentiel de l'électrode de source du transistor MOS de puissance TP. La zone de diode de recirculation ZD comporte également une deuxième jonction de diode notée 102, laquelle, étant susceptible de constituer la jonction émetteur base du transistor parasite tp représenté en trait mixte sur la figure 3a, est court-circuitée. Le court-circuit est représenté par l'anotation 402.

La zone de diode de recirculation ZD comporte également une troisième jonction de diode 113, constituant la diode de recirculation. La première jonction de diode 101 est polarisée en permanence, en inverse pour constituer le caisson d'isolement de la zone de diode de recirculation ZD. La troisième jonction de diode 113 constitue alors la diode de recirculation et est ainsi isolée par le caisson d'isolement 101, en l'absence de courant de conduction parasite du transitor parasite tp, pour lequel la jonction de diode 102 constitue la jonction émetteur base et la jonction de diode 101 constitue la jonction collecteur base. La diode de recirculation 113 est ainsi isolée du fait de la mise en court-circuit de la jonction émetteur base du transistor parasite tp, lequel est ainsi bloqué.

Selon un aspect particulièrement avantageux du régulateur monolithique objet de l'invention tel que représenté en figure 3a, la mise en court-circuit 402 de la deuxième jonction de diode 102, peut avantageusement être constituée par une métallisation recouvrant en surface du substrat, la surface d'intégration de celui-ci, les zones de matériau semi-conducteur constituant la deuxième jonction de diode 102. Sur la figure 3a, on a respectivement désigné les zones de matériau semi-conducteur constitutives du substrat S par la zone C, la zone constitutive de la première jonction de diode 101 avec le matériau semi-conducteur du substrat par la désignation B, la zone de matériau semi-conducteur constitutive avec la zone précédente de la jonction de diode 102, par A, et la zone de matériau semi-conducteur constitutive de l'anode de la jonction de diode de recirculation 113 par D.

Ainsi qu'on l'a représenté en outre en figure 3a, la zone D de matériau semi-conducteur constitutive de l'anode de la diode de recirculation 113, comporte en surface, une métallisation de connexion notée 403 connectée d'une part au potentiel de référence et d'autre part à la borne de l'inducteur 1. La métallisation 402 effectuant la mise en court-circuit de la deuxième jonction de diode 102 est elle-même connectée à la borne commutée de l'inducteur 1 et à l'électrode de source du transistor de puissance de type MOS TP.

Dans un mode de réalisation avantageux non limitatif, le substrat S et le matériau semi-conducteur désigné par C est de type N et la première jonction de diode 101 est constituée par une première zone B de matériau semi-conducteur de type P diffusé dans le substrat. La deuxième jonction de diode 102 est constituée par la deuxième zone A de matériau semi-conducteur de type N, diffusée dans la première zone B de matériau semi-conducteur diffusé. La troisième jonction de diode 113 est constituée par la troisième zone D de matériau semi-conducteur de type P, diffusé dans la deuxième zone A de matériau semi-conducteur diffusé. Bien entendu, les différentes zones diffusées précédemment décrites relatives à la zone de diode de recirculation ZD ou même à la zone de circuit de commutation ZC et au transistor de puissance TP peuvent être obtenues par diffusion de matériau de dopage par la technique de masquage classique dans la réalisation de circuits intégrés. Ces opérations de réalisation ne seront pas décrites car elles correspondant à des opérations classiques dans la technique des circuits intégrés.

Ainsi qu'on l'a représenté en figure 3a, l'anode de la diode de recirculation, la zone de matériau semi-conducteur notée D, peut être constituée par une diffusion de type P base et la cathode de cette même diode peut être constituée par une couche N, la zone de matériau semi-conducteur notée A, épitaxiée. Le tout est placé dans le caisson d'isolement constitué par la jonction 101, cette jonction étant elle-même constituée par la diffusion de matériau de type P, zone de matériau semi-conducteur notée B dans le matériau de type N désigné par C constituant le substrat S. Les différents caissons d'isolement 101 et 201 n'ont aucun point commun et sont totalement isolés.

De la même manière que dans le cas de la figure 2 au point a) de celle-ci, le transistor parasite est en figure 3a, représenté en pointillé dans l'épaisseur du caisson d'isolement. Le court-circuit de la jonction émetteur base du transistor parasite tp est réalisé par la métallisation 402 qui relie la couche épitaxiée de type N désignée par A à la diffusion de matériau de type P désignée par B. Cette métallisation 402 est ainsi que déjà mentionnée, connectée à la borne commutée de l'inducteur 1 et à l'électrode de source du transistor MOS de puissance TP.

Le potentiel du caisson d'isolement constitué par la jonction de diode 101 est donc variable, mais celui-ci assure toujours sa fonction d'isolement pour les raisons ci-après :
- il reste toujours un potentiel inférieur à la tension positive d'alimentation batterie notée +Vbat à laquelle est en fait porté le substrat S ainsi que représenté en figure 3a.
- il n'est pas relié au caisson voisin constitué par la jonction de diode 201, laquelle est reliée au potentiel de référence du dispositif, par la métallisation notée 404.

Sur la figure 3b, on a représenté le schéma équivalent électrique de l'implantation des différents éléments représentés en figure 3a.

On comprendra bien entendu que les modes d'implantation tels que représentés en figure 3a et 2 au point a) de celle-ci, concernent bien la configuration d'une cellule MOS de puissance élémentaire notée TP, une pluralité de ces cellules MOS pouvant, ainsi que précédemment mentionné, être connectées en parallèle pour constituer le transistor de puissance MOS proprement dit TP, et une pluralité de zones de circuits de commande ZC et de zone de diode de recirculation ZD pouvant être également intégrées sur un même substrat et connectées en parallèle pour constituer par exemple, dans le cas de la figure 2 points a) et b) la diode équivalente de recirculation 102 et les diodes d'isolement 101, 201 ou dans le cas de la figure 3a et de la figure 3b la diode de recirculation 113.

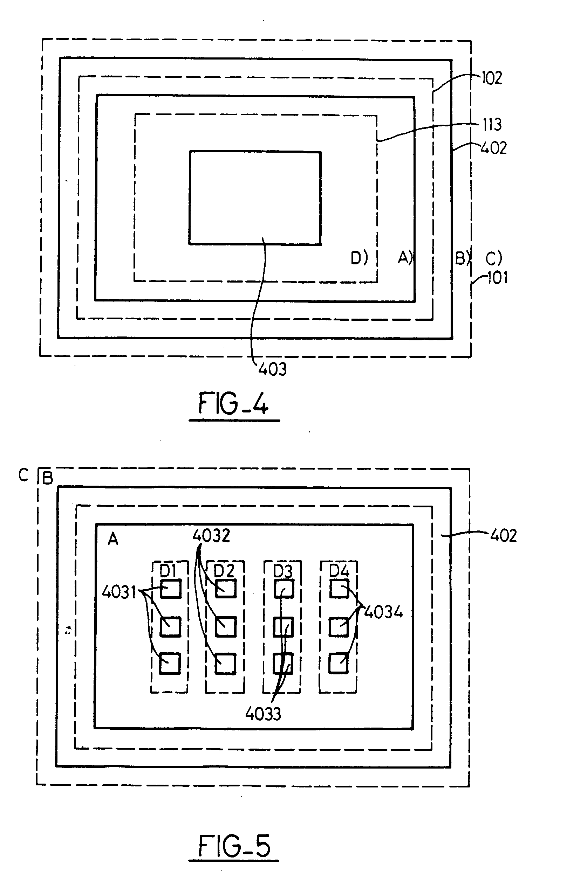

Différentes configurations d'implantation des zones A, B, C, D, d'une zone de diode de recirculation ZD telles que représentées en figure 3a, seront maintenant décrites en liaison avec les figures 4, 5 et 6.

Conformément à figure 4 précitée, la métallisation 402 recouvrant en surface les zones de matériau semi-conducteur constituant la deuxième jonction de diode 102, peut être formée sur la surface d'intégration du substrat S. Elle peut avantageusement présenter la forme d'une boucle fermée, ainsi que représenté sur la figure 4 précitée et la métallisation de connexion 403 disposée en surface de la zone du matériau semi-conducteur constitutif de l'anode de la diode de recirculation 113 peut être alors disposée à l'intérieur de la boucle fermée 102. Sur la figure 4 précitée, les jonctions diodes première jonction diode 101, deuxième jonction diode 102, troisième jonction diode 113 correspondant à la délimitation des zones de diffusion précitées, ont été représentées en trait mixte.

Selon une autre variante de réalisation particulièrement avantageuse représentée en figure 5, la zone D de matériau semi-conducteur constitutive de la diode de recirculation de la jonction de diode 113 est constituée avantageusement par une pluralité de zones élémentaires distinctes, diffusées, ces zones étant notées de manière non limitative, D1, D2, D3, D4. Ces zones peuvent être obtenues par diffusions P-base multiples, l'augmentation du périmètre de diffusion, c'est-à-dire de la longueur du contour délimitant les différentes zones, permet d'augmenter l'efficacité de la jonction de diode correspondante.

En outre, la métallisation 403 de connexion disposée en surface de la zone D de matériau semi-conducteur constitutive de l'anode de la diode de recirculation 113, est alors formée sur chaque zone élémentaire distincte diffusée D1, D2, D3, D4, par une pluralité de métallisations distinctes notées 4031, 4032, 4033, 4034. Chaque métallisation distincte 4031, respectivement 4032, 4033, ou 4034 peut alors être connectée en parallèle pour obtenir la sortie de la diode de recirculation 113.

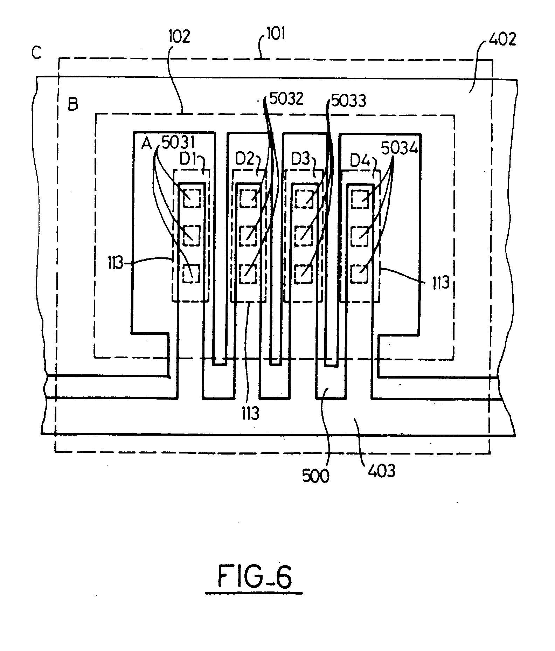

Un dernier mode de réalisation de l'implantation des zones de diffusion en surface du substrat, c'est-à-dire sur la surface d'intégration de celui-ci sera décrit en liaison avec la figure 6. Conformément à la figure 6 précitée, la métallisation 402 recouvrant en surface les zones de matériau semi-conducteur recouvrant la deuxième jonction de diode 102 et la métallisation de connexion 403 disposée en surface de la zone D1, D2, D3, D4, de matériau semi-conducteur constitutif de l'anode de la diode de recirculation 113, sont formées en surface du semi-conducteur S et interdigitées ou imbriquées. Un tel mode de réalisation permet en particulier de diminuer la résistance série de la diode 113 sans augmenter la surface de silicium réservée à cette diode.

Dans ce cas, les métallisations interdigitées 402, 403, sont formées sur le semi-conducteur S, par l'intermédiaire d'une couche d'oxyde de silicium 500. Cette couche d'oxyde de silicium étant électriquement isolante, la pluralité de métallisations 4031, 4032, 4033, 4034, constitutive de la métallisation de connexion disposée en surface de la zone D1, D2, D3, D4, de matériau semi-conducteur constitutive de l'anode de la diode de recirculation 113, est alors constituée par des fenêtres notées 5031, 5032, 5033, 5034 ménagées dans la couche d'oxyde de silicium 500. La métallisation 403 est alors effectuée sur les fenêtres précitées, de façon à assurer le contact électrique avec les zones de diffusion D1, D2, D3, D4 correspondantes.

De manière générale, on comprendra que l'élément de commutation MOS peut être remplacé par un élément de commutation d'une autre nature, un élément de commutation bipolaire par exemple, sans sortir du cadre de l'objet de la présente invention puisque celle-ci concerne plus particulièrement la suppression du transistor parasite lié à la diode de recirculation en parallèle sur l'inductance.

On a ainsi décrit un régulateur monolithique du courant d'excitation de l'inducteur d'un alternateur dans lequel la diode de recirculation est intégrée en technologie d'intégration verticale. Ce type de régulateur est particulièrement avantageux dans la mesure où il permet, la diode de recirculation étant intégrée, de bénéficier de tous les avantages des montages de l'art antérieur, dans lesquels la commutation par rapport au potentiel de la batterie était utilisé, commutation dite "high side".

## Revendications

1. Régulateur monolithique du courant d'excitation de l'inducteur (1) d'un alternateur, comprenant sur un même substrat (S) de matériau semi-conducteur un transistor de puissance (TP) de type MOS, une zone de circuit de commande (ZC) et une zone de diode de recirculation (ZD), caractérisé en ce que chacune desdites zones (ZC,ZD) est isolée dudit substrat (S) par un caisson d'isolement indépendant formant une jonction de diode (101,201) avec le substrat, le caisson d'isolement (101) de la zone de diode de recirculation formant une premiere jonction de diode (101) avec ledit substrat et en ce que ladite zone de diode de recirculation (ZD) forme au moins une deuxieme jonction de diode (102), les au moins deux jonctions de diodes (101, 102) étant en cascade et susceptibles, lors de l'inversion de polarité de la tension appliquée audit inducteur (1), de constituer un transitor parasite (tp), ladite deuxieme jonction diode (102) susceptible de constituer la jonction émetteur-base dudit transistor parasite (tp) est court-circuitée par des moyens de connexion (103) de façon à supprimer le courant de conduction parasite dudit transistor parasite (tp).

2. Régulateur selon la revendication 1, caractérisé en ce que lesdits moyens de connexion (103) permettant la mise en court-circuit de ladite jonction émetteur base (102) comportent :
- un transistor de type MOS (1030) dont l'électrode de grille recouvre les zones de matériau semi-conducteur constituant ladite jonction émetteur-base,
- un comparateur (1031) dont la borne positive et négative est respectivement reliée à la tension de référence et à la borne commutée de l'inducteur.

3. Régulateur selon la revendication 2, caractérisé en ce que l'électrode de grille dudit transistor MOS (1030) est constituée en silicium polycristallin et présente une largeur de recouvrement (1) de ladite jonction émetteur base (102) permettant d'imposer le potentiel des zones de matériau semi-conducteur constitutives de ladite jonction (102).

4. Régulateur selon la revendication 1, caractérisé en ce que ladite zone de diode de recirculation (ZD) comporte, disposées en cascade :
- une première jonction de diode (101) consituant ledit caisson d'isolement, portée à un potentiel flottant,
- une deuxième jonction de diode (102), ladite jonction de diode (102) susceptible de constituer la jonction émetteur base dudit transistor parasite, étant court-circuitée (402),
- une troisième jonction de diode (113) constituant ladite diode de recirculation, ladite première jonction de diode (101) étant polarisée en permanence en inverse pour constituer ledit caisson d'isolement, ladite troisième jonction de diode (113) constituant ladite diode de recirculation étant ainsi isolée par ledit caisson d'isolement en l'absence de courant de conduction parasite dudit transistor parasite (tp).

5. Régulateur selon la revendication 4, caractérisé en ce que la mise en court-circuit (402) de ladite deuxième jonction de diode (102) est constituée par une métallisation recouvrant en surface les zones de matériau semi-conducteur constituant ladite deuxième jonction de diode (102).

6. Régulateur selon les revendications 4 et 5, caractérisé en ce que la zone (D) de matériau semi-conducteur constitutive de l'anode de ladite diode de recirculation (113) comporte en surface une métallisation de connexion (403) connectée d'une part au potentiel de référence et d'autre part à la borne de l'inducteur (1), ladite métallisation (402) effectuant la mise en court-circuit de ladite deuxième jonction de diode (102) étant connectée à la borne commutée dudit inducteur (1) et à l'électrode de source dudit transistor de puissance de type MOS (TP).

7. Régulateur selon l'une des revendications 3 à 6, caractérisé en ce que ledit substrat (S) est un matériau (C) de type N, ladite première jonction de diode (101) étant constituée par une première zone (B) de matériau semi-conducteur de type P diffusée dans ledit substrat, ladite deuxième jonction de diode (102) étant constituée par une deuxième zone (A) de matériau semi-conducteur diffusée.

8. Régulateur selon l'une des revendications 5 à 7, caractérisé en ce que ladite métallisation (402) recouvrant en surface les zones de matériau semi-conducteur constituant ladite deuxième jonction de diode (102) est formée sur la surface d'intégration du substrat (S) et présente la forme d'une boucle fermée, ladite métallisation de connexion (403) disposée en surface de la zone de matériau semi-conducteur constitutive de l'anode de la diode de recirculation étant diposée à l'intérieur de ladite boucle fermée.

9. Régulateur selon l'une des revendications 5 à 7, caractérisé en ce que la zone (D) de matériau semi-conducteur constitutive de l'anode de la diode de recirculation est constituée par une pluralité de zones élémentaires distinctes (D1,D2,D3,D4) diffusées, ladite métallisation (403) de connexion disposée en surface de la zone (D) de matériau semi-conducteur constitutive de l'anode de la diode de recirculation (113) étant formée, sur chaque zone élémentaire distincte diffusée (D1,D2,D3,D4) par une pluralité de métallisations distinctes (4031,4032, 4033, 4034).

10. Régulateur selon l'une des revendications 5 à 7 et 9, caractérisé en ce que ladite métallisation (402) recouvrant en surface les zones de matériau semi-conducteur constituant ladite deuxième jonction de diode (102) et la dite métallisation (403) disposée en surface de la zone (D1,D2,D3,D4) de matériau semi-conducteur constitutive de l'anode de la diode de recirculation sont formées en surface du semi-conducteur (S) et interdigitées.

11. Régulateur selon les revendications 9 et 10, caractérisé en ce que lesdites métallisations interdigitées (402,403) sont formée sur le semi-conducteur (S) par l'intermédiaire d'une couche d'oxyde de silicium (500), ladite pluralité de métallisations distinctes (4031,4032,4033,4034) constitutives de ladite métallisation de connexion disposée en surface de la zone (D1,D2,D3,D4) de matériau semi-conducteur constitutive de l'anode de la diode de recirculation étant constituée par des fenêtres (5031,5032,5033, 5034) ménagées dans ladite couche d'oxyde de silicium (500) sur lesquelles ladite métallisation est effectuée.

## Claims

1. A monolithic regulator for the excitation current of the field coil (1) of an alternator, comprising, on a common substrate (S) of semiconductor material, a power transistor (TP) of the MOS type, a control circuit zone (ZC), and a recirculating diode zone (ZD), characterized in that each of the said zones (ZC, ZD) is insulated from the said substrate (S) by an independent insulating barrier element defining a diode junction (101, 201) with the substrate, the insulating barrier element (101) of the recirculating diode zone defining a first diode junction (101) with the said substrate, and in that the said recirculating diode zone (ZD) defines at least one second diode junction (102), the at least two diode junctions (101, 102) being in cascade and being such that, upon inversion of polarity of the voltage applied to the said field coil (1), they constitute a parasitic transistor (tp), the said second diode junction (102) for constituting the emitter-base junction of the said parasitic transistor (tp) is short-circuited by connection means (103) whereby to suppress the parasitic conduction current of the said parasitic transistor (tp).

2. A regulator according to Claim 1, characterised in that the said connection means (103) which enable the said emitter-base junction (102) to be short-circuited comprise:
- a transistor (1030) of MOS type, the grid electrode of which overlies the zones of semiconductor material constituting the said emitter-base junction,
- a comparator (1031), the positive and negative terminals of which are respectively connected to the reference voltage and to the commutated terminal of the field coil.

3. A regulator according to Claim 2, characterised in that the grid electrode of the said MOS transistor (1030) is made of polycrystalline silicone and defines an interface width (1) which overlies the said emitter-base junction (102), such as to impose the potential of the zones of semiconductor material constituting the said junction (102).

4. A regulator according to Claim 1, characterised in that the said recirculation diode zone (ZD) comprises, disposed in cascade:
- a first diode junction (101) constituting the said insulating barrier element, brought to a floating potential,
- a second diode junction (102), this diode junction (102), for constituting the emitter-base junction of the said parasitic transistor, being short circuited (402),
- a third diode junction (113) constituting the said recirculation diode, the said first diode junction (101) being permanently inversely polarised so as to constitute the said insulating barrier element, the said third diode junction (113) constituting the said recirculation diode being thus insulated by the said insulating barrier element in the absence of parasitic conduction current from the said parasitic transistor (tp).

5. A regulator according to Claim 4, characterised in that the short circuiting (402) of the said second diode junction (102) is provided by a metallised surface coating overlying the zones of semiconductor material constituting the said second diode junction (102).

6. A regulator according to Claims 4 and 5, characterised in that the zone (D) of semiconductor material constituting the anode of the said recirculation diode (113) includes a metallised connection surface layer (403) connected firstly to the reference potential and secondly to the terminal of the field coil (1), the said metallised coating (402) that effects the short-circuiting of the said second diode junction (102) being connected to the commutated terminal of the said field coil (1) and to the source electrode of the said power transistor of the MOS type (TP).

7. A regulator according to one of Claims 3 to 6, characterised in that the said substrate (S) is of an N-type material (C), the said first diode junction (101) comprising a first zone (B) of P-type semiconductor material diffused in the said substrate, the said second diode junction (102) comprising a second zone (A) of diffused semiconductor material.

8. A regulator according to one of Claims 5 to 7, characterised in that the said metallised surface coating (402) overlying the zones of semiconductor material constituting the said second diode junction (102) is formed on the integration surface of the substrate (S) and has the form of a closed loop, the said metallised connection coating (403), disposed on the surface of the zone of semiconductor material which constitutes the anode of the recirculation diode, being disposed within the said closed loop.

9. A regulator according to one of Claims 5 to 7, characterised in that the zone (D) of semiconductor material constituting the anode of the recirculation diode comprises a plurality of distinct diffused elementary zones (D1, D2, D3, D4), the said metallised connection coating (403), disposed on the surface of the zone (D) of semiconductor material which constitutes the anode of the recirculation diode (113), being defined on each distinct diffused elementary zone (D1, D2, D3, D4) by a plurality of distinct metallisations (4031, 4032, 4033, 4034).

10. A regulator according to one of Claims 5 to 7 and 9, characterised in that the said metallised surface coating (402) overlying the zones of semiconductor material constituting the said second diode junction (102), and the said metallised surface coating (403) disposed on the surface of the zone (D1, D2, D3, D4) of semiconductor material which constitutes the anode of the recirculation diode, are formed on the surface of the semiconductor (S) and are interleaved.

11. A regulator according to Claims 9 and 10, characterised in that the said interleaved metallised coatings (402, 403) are formed on the semiconductor (S) by the intermediate means of a layer of silicon oxide (500), the said plurality of distinct metallisations (4031, 4032, 4033, 4034) that constitute the said metallised connection coating, disposed on the surface of the zone (D1, D2, D3, D4) of semiconductor material which constitutes the anode of the recirculation diode, being defined by windows (5031, 5032, 5033, 5034) formed in the said layer of silicon oxide (500) on which the said metallisation is performed.

## Patentansprüche

1. Monolithischer Regulator des Induktionsanregungsstromes (1) eines Wechselstromgenerators, enthaltend auf dem gleichen Substrat (S) aus Halbleitermaterial einen Leistungstransistor (TP) vom Typ MOS, eine Steuerkreiszone (ZC) und eine Wiederdurchflußdiodenzone (ZD), **dadurch gekennzeichnet,** daß jede der genannten Zonen (ZC, ZD) gegen das genannte Substrat (S) durch einen als Verbindung zwischen Diode (101, 102) und dem Substrat dienenden, unabhängigen Isolierkasten getrennt ist, wobei der Isolierkasten (101) der Wiederdurchflußdiodenzone eine erste Verbindung der Diode (101) mit dem genannten Substrat bildet, und daß die genannte Wiederdurchflußdiodenzone (ZD) wenigstens eine zweite Diodenverbindung (102) bildet, wobei die wenigstens zwei Diodenverbindungen (101, 102) in Kaskade geschaltet sind und geeignet sind, bei Umkehrung der Polarität der an den genannten Induktor (1) angelegten Spannung einen Störtransistor (tp) zu bilden, während die genannte zweiten Diodenverbindung (102), die zur Bildung der Emitter-Basis-Verbindung des genannten Störtransistors (tp) geeignet ist, durch Verbindungsmittel (103) so kurzgeschlossen ist, daß der Störleitungsstrom des genannten Störtransistors (tp) unterdrückt wird.

2. Regulator nach Anspruch 1, **dadurch gekennzeichnet,** daß die genannten Verbindungsmittel (103) das Kurzschließen der genannten Emitter-Basis-Verbindung (102) ermöglichen und folgendes enthalten:
- einen Transistor vom Typ MOS (1030), dessen Steuerelektrode die Halbleitermaterialzonen, die die genannte Emitter-Basis-Verbindung bilden, bedeckt,
- einen Komparator (1031), dessen Plus- und Minusklemmen mit der Bezugsspannung bzw. der umgeschalteten Induktorklemme verbunden sind.

3. Regulator nach Anspruch 2, **dadurch gekennzeichnet,** daß die Steuerelektrode des genannten Transistors MOS (1030) aus polykristallinem Silicium besteht und eine Abdeckungsbreite (1) der genannten Emitter-Basis-Verbindung (102) aufweist, die es ermöglicht, das Potential der Halbleitermaterialzonen, die die genannte Verbindung (102) bilden, anzulegen.

4. Regulator nach Anspruch 1, **dadurch gekennzeichnet,** daß die genannte Wiederdurchflußdiodenzone (ZD) in Kaskadenschaltung folgendes enthält:
- eine erste Diodenverbindung (101), die den genannten Isolierkasten bildet, auf Schwebespannung gebracht,
- eine zweite Diodenverbindung (102), wobei die genannte Diodenverbindung (102) geeignet ist, die Emitter-Basis-Verbindung des genannten Störtransistors zu bilden, in Kurzschlußschaltung (402),
- eine dritte Diodenverbindung (113), die die genannte Wiederdurchflußdiode bildet, wobei die genannte erste Diodenverbindung (101) ständig umgekehrt gepolt ist, um den genannten Isolierkasten zu bilden, während die genannte dritte Diodenverbindung (113) die genannte Wiederdurchflußdiode bildet und somit durch den genannten Isolierkasten isoliert ist, wenn kein Störleitungsstrom vom genannten Störtransistor (tp) vorhanden ist.

5. Regulator nach Anspruch 4, **dadurch gekennzeichnet,** daß die Kurzschlußschaltung (402) der genannten zweiten Diodenverbindung (102) durch einen Metallüberzug bewirkt wird, der die Oberfläche der Halbleitermaterialzonen, welche die genannte zweite Diodenverbindung (102) bilden, bedeckt.

6. Regulator nach den Ansprüchen 4 und 5, **dadurch gekennzeichnet,** daß die Halbleitermaterialzone (D), die die Anode der genannten Wiederdurchflußdiode (113) bildet, an der Oberfläche einen Verbindungsüberzug (403) aufweist, der einerseits an das Bezugspotential und andererseits an die Klemme des Induktors (1) angeschlossen ist, wobei der genannte Metallüberzug (402) das Kurzschließen der genannten zweiten Diodenverbindung (102) bewirkt, die an die umgeschaltete Klemme des genannten Induktors (1) und an die Source-Elektrode des genannten Leistungstransistors vom Typ MOS (TP) angeschlossen ist.

7. Regulator nach einem der Ansprüche 3 bis 6, **dadurch gekennzeichnet,** daß das genannte Substrat (S) ein Material (C) vom Typ N ist, wobei die genannte erste Diodenverbindung (101) aus einer ersten Streuzone (B) aus Halbleitermaterial vom Typ P im genannten Substrat besteht, während die genannte zweite Diodenverbindung (102) aus einer zweiten Streuzone (A) aus Halbleitermaterial besteht.

8. Regulator nach einem der Ansprüche 5 bis 7, **dadurch gekennzeichnet,** daß der genannte Metallüberzug (402), der die Oberfläche der Halbleitermaterialzonen bedeckt, die die genannte zweite Diodenverbindung (102) bilden, auf der Integrationsoberfläche des Substrats (S) ausgebildet wird und die Form einer geschlossenen Schleife aufweist, wobei der genannte verbindende Metallüberzug (403), der an der Oberfläche der Halbleitermaterialzone liegt, die die Anode der Wiederdurchflußdiode bildet, im Innern der genannten geschlossenen Schleife angeordnet ist.

9. Regulator nach einem der Ansprüche 5 bis 7, **dadurch gekennzeichnet,** daß die Halbleitermaterialzone (D), die die Anode der Wiederdurchflußdiode bildet, aus einer Vielzahl von verschiedenen, verteilten Elementarzonen (D1, D2, D3, D4) besteht, wobei der genannte verbindende Metallüberzug (403), der an der Oberfläche der Halbleitermaterialzone (D) liegt, die die Anode der Wiederdurchflußdiode (113) bildet, in jeder unterschiedlichen, verteilten Elementarzone (D1, D2, D3, D4) durch eine Vielzahl verschiedener Metallüberzüge (4031, 4032, 4033, 4034) gebildet wird.

10. Regulator nach einem der Ansprüche 5 bis 7 und 9, **dadurch gekennzeichnet,** daß der genannte Metallüberzug (402), der die Oberfläche der Halbleitermaterialzonen bedeckt, welche die genannte zweite Diodenverbindung (102) bilden, und der genannte Metallüberzug (403), der an der Oberfläche der Halbleitermaterialzone (D1, D2, D3, D4) liegt, welche die Anode der Wiederdurchflußdiode bildet, an der Oberfläche des Halbleiters (S) ausgebildet und parallelgeschaltet sind.

11. Regulator nach den Ansprüchen 9 und 10, **dadurch gekennzeichnet,** daß die genannten parallelgeschalteten Metallüberzüge (402, 403) auf dem Halbleiter (S) mittels einer Siliciumoxidschicht (500) ausgebildet sind, wobei die genannte Vielzahl von verschiedenen Metallüberzügen (4031, 4032, 4033, 4034), die den genannten verbindenden Metallüberzug an der Oberfläche der Halbleitermaterialzone (D1, D2, D3, D4) bilden, woraus die Anode der Wiederdurchflußdiode besteht, von Fenstern (5031, 5032, 5033, 5034) gebildet werden, die in der genannten Siliciumoxidschicht (500) angebracht sind, woran der genannte Metallüberzug vorgenommen wird.
